# EUROPEAN PATENT APPLICATION

(11) **EP 2 640 042 A1**
(43) Date of publication of application: **18.09.2013**
(21) Application number: 13158586.1
(22) Date of filing: 11.03.2013
(51) Int. Cl.: H04M 1/02, B29C 45/16, G06F 1/16, H04B 1/38, H04M 1/18, H05K 5/06

(54) **Waterproof case for portable terminal**

(30) Priority: 13.03.2012 KR 20120025358
(71) Applicant: Samsung Electronics Co., Ltd, Gyeonggi-do 443-742 (KR)
(72) Inventor: Kim, Jin-Yong, 443-742 Gyeonggi-do (KR); Wee, Jong-Cheon, 443-742 Gyeonggi-do (KR); Cho, Soon-Min, 443-742 Gyeonggi-do (KR); Choi, Hwan-Seok, 443-742 Gyeonggi-do (KR)
(74) Representative: Nederlandsch Octrooibureau

(57) **Abstract**

A waterproof case for a portable terminal is provided. The waterproof case includes a waterproof member assembled to the portable terminal to wrap an outer perimeter of the portable terminal, the waterproof member being formed with an opening for partially exposing the portable terminal, a protective member configured to wrap an outer perimeter of the waterproof member, the protective member being integrally formed with the waterproof member through dual injection molding, and a waterproof rib formed from an elastic material around the opening on an inner surface of the waterproof member, the waterproof rib being configured to come into close contact with the outer perimeter of the portable terminal.

## Description

### BACKGROUND OF THE INVENTION

### 1. Field of the Invention:

The present invention relates to an additional device for a portable terminal. More particularly, the present invention relates to a detachable waterproof case configured to provide a waterproof function in daily life.

### 2. Description of the Related Art:

In general, a portable terminal corresponds to a device that enables a user to enjoy a communication function with another user, a data communication function, such as access to Internet, mobile banking and multimedia file transfer, access to games or music, and/or a multimedia function, such as reproduction of moving images. Prior to recent technological advancements, such a portable terminal was generally specialized to an individual function, for example, a communication function, a game function, a multimedia function, an electronic scheduler function, or the like. However, due to the recent development of electric/electronic technologies and telecommunication technologies, it has become possible to enjoy various functions with a single portable terminal. In other words, because of recent advancements, a portable terminal may correspond to a single communication terminal that performs multiple functions previously performed by independent devices.

Portable terminal users generally use a protective case with their portable terminals in order to prevent the portable terminal from being damaged by scratches or from being fractured by impact. In addition, because of the increasing importance of portable terminals to their users, portable terminals increasingly are becoming exposed to water leisure sport activities or winter-season leisure sport activities. Consequently, it becomes necessary to provide a waterproof function to a portable terminal in order to prevent water from infiltrating into the portable terminal. Protective cases according to the related art which are frequently used to protect the portable terminal from scratches or impact, do not provide a waterproof function. For example, although protective cases according to the related art may provide protection to an external appearance of the portable terminal or an ornamental design to the portable terminal, such protective cases do not protect the portable terminal from water to which the portable terminal may be exposed. Therefore, it is necessary to use a separate waterproof case in order to provide a waterproof function required in a special environment.

An end user of a portable terminal usually purchases and uses a bag-shaped waterproof case. The users may simply carry such a bag-shaped waterproof case, and may carry a portable terminal in a state in which the portable terminal is put into the waterproof case to be sealed, as desired. Another type of waterproof structure easily used by the end user is configured to wrap a terminal with vinyl or the like, to seal the rear side of the terminal with adhesive tape or the like, and then to couple a separate protective case thereto. Although the bag-shaped protective case and the protective case wrapped by vinyl as described above are advantageous in that they can be easily used and are inexpensive, they reveal a limitation in repeated use due to poor durability. In addition, the protective cases have a disadvantage in that they deteriorate the readability of a display device because the waterproof case and the vinyl have a low transmittance and may cause screen distortion when crumpled.

There is another type of waterproof case that is constituted by combining a first case part for enclosing the front side of a terminal and a second case part for enclosing the rear side of the terminal. The waterproof case with this configuration is adapted to provide a sealing member for strengthening the waterproof performance in the inside thereof while enclosing the entirety of the terminal. At this time, a waterproof case fabricated to be used only for a specific terminal may allow an external device and the terminal to be connected with each other through a separate cable. However, a waterproof case fabricated to be commonly used for any terminal requires the separation of a terminal in order to connect the terminal with an external device. In other words, those protective cases which enable a user to connect an external device to the portable terminal and which protect the portable terminal enclosed therein from water must be specifically designed for the portable terminal. The waterproof case constituted by combining two case parts as described above includes a separate locking device so as to keep the first and second case parts joined and sealed while the waterproof case is in use. However, the waterproof case constituted by combining the first and second case parts practically makes it impossible to manipulate the terminal. In addition, due to the large volume thereof, it is impossible to use the waterproof case in daily life. Furthermore, the waterproof case has a problem in that the waterproof case deteriorates the readability of a display device because the screen of the display device is viewed through the first or second case.

As multimedia services through portable terminals have been strengthened recently, it is a recent trend to mount a touch screen to a portable terminal in place of a physical keypad. In this circumstance, an ordinary protective case provides merely an ornamental function or a protective function against physical impact, and a waterproof case practically makes it impossible to manipulate a terminal in a state in which the case provides a waterproof function to the terminal.

Therefore, a need exists for an a waterproof case for a portable terminal which is reduced in size and slimmed to be capable of providing an ornamental function and a protective function against physical impact like an ordinary protective case while providing a waterproof function in daily life.

The above information is presented as background information only to assist with an understanding of the present disclosure. No determination has been made, and no assertion is made, as to whether any of the above might be applicable as prior art with regard to the present invention.

### SUMMARY OF THE INVENTION

Aspects of the present invention are to address at least the above-mentioned problems and/or disadvantages and to provide at least the advantages described below. Accordingly, an aspect of the present invention is to provide a waterproof case for a portable terminal which is reduced in size and slimmed to be capable of providing an ornamental function and a protective function against physical impact like an ordinary protective case while providing a waterproof function in daily life.

Another aspect of the present invention is to provide a waterproof case for a portable terminal which opens a part of the terminal, in particular a display device to prevent the deterioration of picture quality, and to enable the manipulation of a touch screen while providing a waterproof function in daily life.

In accordance with an aspect of the present invention, a waterproof case for a portable terminal is provided. The waterproof case includes a waterproof member assembled to the portable terminal to wrap an outer perimeter of the portable terminal, the waterproof member being formed with an opening for partially exposing the portable terminal, a protective member configured to wrap an outer perimeter of the waterproof member, the protective member being integrally formed with the waterproof member through dual injection molding, and a waterproof rib formed from an elastic material around the opening on an inner surface of the waterproof member, the waterproof rib being configured to come into close contact with the outer perimeter of the portable terminal.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of certain exemplary embodiments of the present invention will be more apparent from the following description taken in conjunction with the accompanying drawings, in which:

FIG. 1 is an exploded perspective view illustrating a waterproof case for a portable terminal in accordance with an exemplary embodiment of the present invention;

FIG. 2 is a perspective view illustrating a portable terminal coupled to a waterproof case such as, for example, the waterproof case illustrated in FIG. 1, according to an exemplary embodiment of the present invention;

FIG. 3 is a cross-sectional view taken by cutting a part of a waterproof case such as, for example, the waterproof case illustrated in FIG. 2, according to an exemplary embodiment of the present invention;

FIG. 4 is a cross-sectional view taken by cutting a waterproof rib along line A-A' indicated in FIG. 3 according to an exemplary embodiment of the present invention;

FIG. 5 is a cross-sectional view illustrating a variant embodiment of a waterproof rib such as, for example, the waterproof rib illustrated in FIG. 3, according to an exemplary embodiment of the present invention;

FIG. 6 is a cross-sectional view illustrating another variant embodiment of a waterproof rib such as, for example, the waterproof rib illustrated in FIG. 3, according to an exemplary embodiment of the present invention;

FIG. 7 is a cross-sectional view illustrating still another variant embodiment of a waterproof rib such as, for example, the waterproof rib illustrated in FIG. 3, according to an exemplary embodiment of the present invention;

FIG. 8 is a cross-sectional view illustrating a sealing member coupled to a waterproof case such as, for example, the waterproof case illustrated in FIG. 2, according to an exemplary embodiment of the present invention;

FIG. 9 is a cross-sectional view illustrating a variant embodiment of a sealing member coupled to a waterproof case such as, for example, the sealing member of FIG. 1, according to an exemplary embodiment of the present invention;

FIG. 10 is a perspective view illustrating a sealing member such as, for example, the sealing member of FIG. 9, according to an exemplary embodiment of the present invention; and

FIG. 11 is a perspective view illustrating a sealing member coupled to a waterproof case such as, for example, the sealing member of FIG. 9, according to an exemplary embodiment of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, description of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

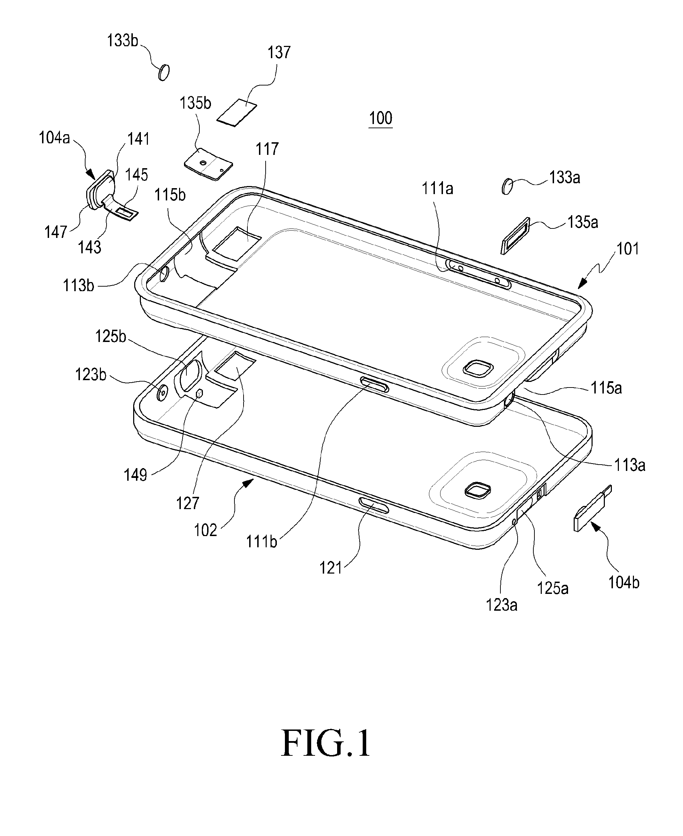

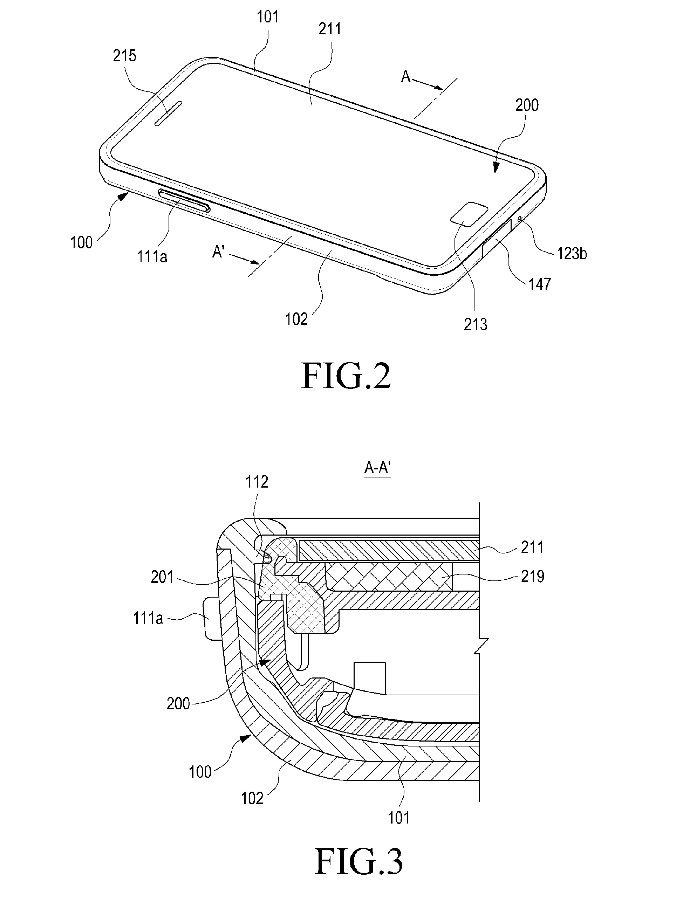

FIG. 1 is an exploded perspective view illustrating a waterproof case for a portable terminal in accordance with an exemplary embodiment of the present invention. FIG. 2 is a perspective view illustrating a portable terminal coupled to a waterproof case such as, for example, the waterproof case illustrated in FIG. 1, according to an exemplary embodiment of the present invention. FIG. 3 is a cross-sectional view taken by cutting a part of a waterproof case such as, for example, the waterproof case illustrated in FIG. 2, according to an exemplary embodiment of the present invention.

Referring to FIGs. 1 to 3, a waterproof case 100 for a portable terminal 200 in accordance with an exemplary embodiment of the present invention includes a waterproof member 101, a protective member 102, and a waterproof rib 112, in which when the waterproof member 101 wraps the outer perimeter of the portable terminal 200, the waterproof rib 112 comes into close contact with the outer perimeter of the portable terminal 200 so as to provide a waterproof function. According to exemplary embodiments of the present invention, the waterproof member 101 is provided with an opening to partially expose the portable terminal 200. For example, the present exemplary embodiment exemplifies a construction in which the opening is formed to open the front face of the portable terminal 200, so that a display device 219 of the portable terminal 200 is visually exposed. Although FIG. 1 illustrates a construction formed by fabricating each of the waterproof member 101 and the protective member 102 in a predetermined shape and thereafter assembling the waterproof member 101 and the protective member 102, the waterproof member 101 and the protective member 102 are formed of a synthetic resin material. According to exemplary embodiments of the present invention, the waterproof member 101 and the protective member 102 are preferably fabricated in an integrated structure through a dual injection molding process.

According to exemplary embodiments of the present invention, the portable terminal 200 includes a display device 219 (see FIG. 3) protected by a window member 211, and the portable terminal 200 may be provided with a key button 213 disposed at one end portion of the front side thereof, and a receiver module 215 disposed at the other end portion of the front side.

The waterproof member 101 is coupled to wrap the outer perimeter of the portable terminal 200, and the waterproof member 101 is formed from an elastic material such as, for example, rubber, silicone, urethane, and/or the like. Because the waterproof member 101 is formed from an elastic material, the waterproof member 101 itself may come into close contact with the outer perimeter of the portable terminal 200 so as to provide a waterproof function. However, in order to improve the waterproof function, according to exemplary embodiments of the present invention, the waterproof rib 112 is formed on the inner surface of the waterproof member 110. For example, the waterproof rib 112 protrudes from the inner surface of the waterproof member 101, and the waterproof rib 112 is formed to surround the opening, thereby forming a looped curve. The waterproof member 101 tends to come into close contact with the outer perimeter of the portable terminal 200, which makes the tip end of the waterproof rib 112 come into close contact with the outer surfaces of the portable terminal 200. For example, it is possible to secure a more stable waterproof performance by forming the waterproof rib 112.

According to exemplary embodiments of the present invention, the protective member 102 forms the practical outer appearance of the waterproof case 100, and is formed from a rigid synthetic resin such as, for example, a polycarbonate material or the like. The protective member 102 is formed to enclose the outer perimeter of the waterproof member 101, and is fabricated to be integrated with the waterproof member 101. For example, the protective member 102 may be formed so as to be integrated with the waterproof member 101 through dual injection molding. That is, one of the protective member 102 and the waterproof member 101 is firstly molded, and thereafter the other one of the protective member 102 and the waterproof member 101 is molded in a state in which the firstly molded one is inserted into a mold fabricated to form the other member. According to exemplary embodiments of the present invention, the firstly molded one of the protective member 102 and the waterproof member 101 may be selected considering molding conditions, such as, for example, molding temperatures and pressures of the protective member 102 and the waterproof member 101. In general, the member molded under a condition of higher temperature and higher pressure should be the first of the protective member 102 and the waterproof member 101 to be molded.

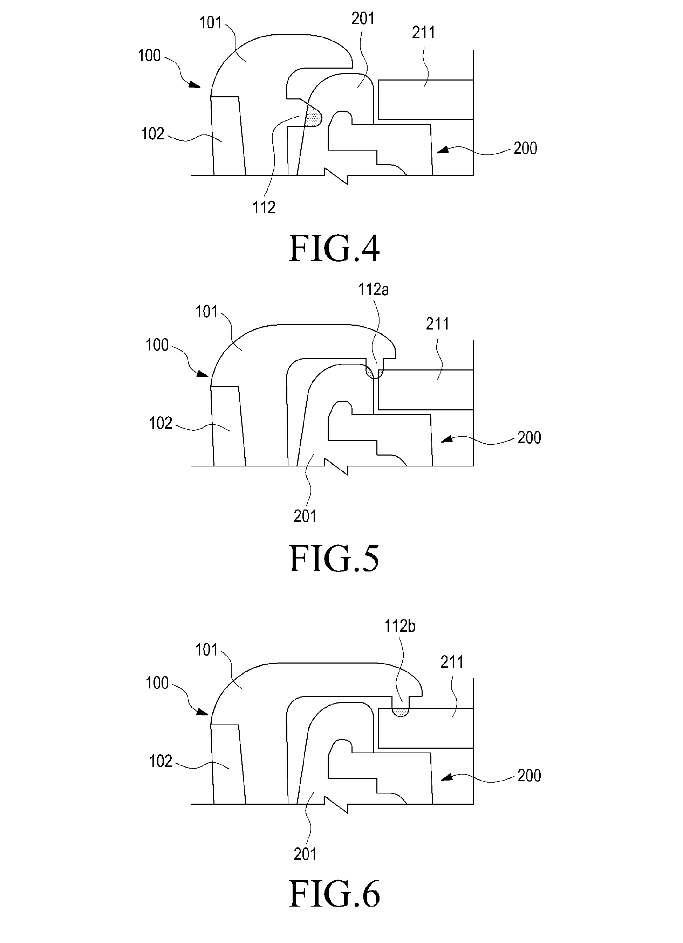

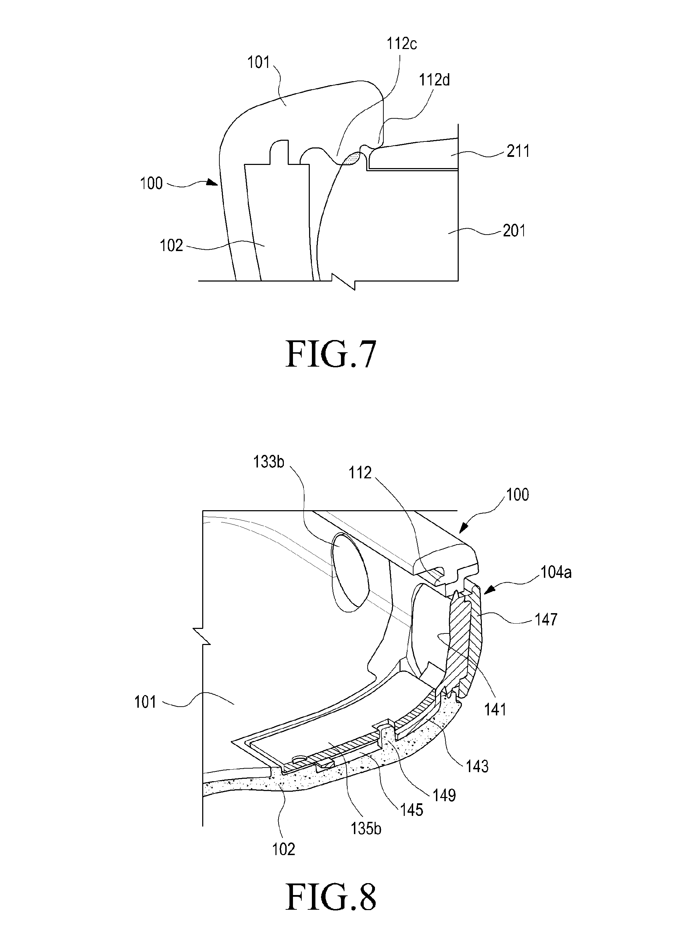

FIG. 4 is a cross-sectional view taken by cutting a waterproof rib along line A-A' indicated in FIG. 3 according to an exemplary embodiment of the present invention. FIG. 5 is a cross-sectional view illustrating a variant embodiment of a waterproof rib such as, for example, the waterproof rib illustrated in FIG. 3, according to an exemplary embodiment of the present invention. FIG. 6 is a cross-sectional view illustrating another variant embodiment of a waterproof rib such as, for example, the waterproof rib illustrated in FIG. 3, according to an exemplary embodiment of the present invention. FIG. 7 is a cross-sectional view illustrating still another variant embodiment of a waterproof rib such as, for example, the waterproof rib illustrated in FIG. 3, according to an exemplary embodiment of the present invention.

Referring to FIGs. 4 to 6, a waterproof rib 112 may be closely contacted at various positions on the outer perimeter of a portable terminal 200. FIG. 4 illustrates a state in which the waterproof rib 112 illustrated in FIG. 3 is closely contacted with a side surface of the portable terminal 200. FIGs. 5 to 7 illustrate variant embodiments of the waterproof rib 112. According to exemplary embodiments of the present invention, it is apparent that in a real product, the waterproof ribs 112, 112a, 112b, 112c and 112d will be deformed and come into close contact with the outer perimeter of the portable terminal 200 at the overlapping parts, which are depicted in shadow, between the waterproof ribs 112, 112a, 112b, 112c and 112d and the housing 201 or window member 211 of the portable terminal 200 illustrated in FIGs. 4 to 7.

According to exemplary embodiments of the present invention, the portable terminal 200 includes a housing 201 forming the practical external appearance of the portable terminal 200, and a window member 211 operatively coupled to the front side of the housing 201, in which the window member 211 transmits a screen displayed on the display device 219 while protecting the display device 219. For example, the window member 211 may operatively transmit light transmitted by the display device 219 such that the screen is viewable through the window member 211 while the window member 211 also protects the display device 219. The boundary between the housing 201 and the window member 211 may be prone to water leakage. Consequently, according to exemplary embodiments of the present invention, a waterproof rib 112a may be configured to prevent water leakage along a boundary between the housing 201 and the window member 211. For example, FIG. 5 illustrates a structure in which the waterproof rib 112a is configured to come into close contract with the outer perimeter of the portable terminal 200 along the boundary between the housing 201 and the window member 211. As a result, the waterproof member 101, more specifically the waterproof rib 112a can assure the stable waterproof performance along the boundary of the housing 201 and the window member 211. FIG. 6 illustrates a construction in which the position of the waterproof rib 112b is changed so that the boundary between the housing 201 and the window member 211 is positioned within the area surrounded by the waterproof member 101 and the waterproof rib 112b. As a result, it is possible to prevent water from approaching to the boundary between the housing 201 and the window member 211, so that the waterproof performance can be secured. FIG. 7 illustrates an example of a construction in which two rows of waterproof ribs 112c and 112d are formed to come into close contact with the outer perimeter of the housing 201 and the outer perimeter of the window member 221, respectively, across the boundary according to an exemplary embodiment of the present invention. As illustrated in FIGs. 5 to 7, the waterproof ribs 112, 112a, 112b, 112c and 112d may be formed at various positions on the outer perimeter of the portable terminal 200.

Referring to FIGs. 4 to 7, the position at which a waterproof rib 112, 112a or 112b comes into close contact may be positioned at any of the lateral sides and front side on the outer perimeter of the portable terminal 200. At this time, when the waterproof rib comes into close contact with the front side of the portable terminal 200, it is noted that the waterproof rib should come into close contact with the boundary between the housing 201 and the window member 211, or the boundary between the housing 201 and the window member 211 should be positioned in a region enclosed by the protective member 102 and the waterproof rib.

According to exemplary embodiments of the present invention, the waterproof case 100 enables inputting and outputting of sound and connection of various connectors even in a state in which the portable terminal 200 is mounted therein.

For example, according to exemplary embodiments of present invention, the waterproof case 100 may be provided with through-holes corresponding to the sound input/output holes of the portable terminal 200. Further, according to exemplary embodiments of the present invention, waterproof and water-permeable films 133a, 133b and 137 may be attached to the through-holes, respectively, so as to provide a waterproof function in daily use. In addition, according to exemplary embodiments of the present invention, the waterproof case 100 may be provided with connector holes connected to various connectors, such as an interface connector or a ear jack of the portable terminal 200, and sealing members 104a and 104b, so that the waterproof case 100 allows the portable terminal 200 and an external device to be interconnected in a state in which the portable terminal 200 is assembled to the waterproof case 100. For example, the waterproof case 100 may include connector holes corresponding sealing members 104a and 104b so as to permit a user to connect an external device to the portable terminal 200 when the portable terminal 200 is mounted in the waterproof case 100. According to exemplary embodiments of the present invention, the term "external device" may correspond to a device, which is connected to the portable terminal 200 (e.g., usually through a cable and a connector), such as, for example, a charger, a personal computer, an earphone, a hands-free headset kit, and the like.

The through-holes are formed to correspond to sound input holes (i.e., holes operatively connected to a microphone), and sound output holes (i.e. holes operatively connected to a speakerphone) of the portable terminal 200, respectively. As an example, the through-holes are formed by interconnecting the holes 113a, 113b and 117 and the holes 123a, 123b and 127 formed in the waterproof member 101 and the protective member 102, respectively, in which the sizes or diameters of the holes 113a, 113b and 117 formed in the waterproof member 101 are larger than those of the holes 123a, 123b and 127 formed in the protective member 102. The waterproof and water-permeable films 133a, 133b and 137 are attached to the through-holes, respectively, so as to prevent the inflow of water. According to exemplary embodiments of the present invention, the waterproof and water-permeable films 133a, 133b and 137 are adhered to the perimeters of the holes 123a, 123b and 127 formed through the protective member 102 on the inner surface of the protective member 102 using a waterproof adhesive tape.

As a result, it is possible for the portable terminal 200 to input or output sound while securing a waterproof performance in daily use in a state in which the portable terminal 200 is assembled to or otherwise installed in the protective case.

The connector holes connected with various connectors, such as, for example, an interface connector and ear jack of the portable terminal 200, are formed to extend through the waterproof case 100. The waterproof case 100 illustrated in FIG. 1 is an example of a construction that is formed with connector holes which correspond to the interface connector and the ear jack of the portable terminal 200, respectively.

According to exemplary embodiments of the present invention, the connector holes are also formed by connecting the holes 115a and 115b and the holes 125a and 125b, which are formed in the waterproof member 101 and the protective member 102, respectively, and are configured to be opened or closed by separate sealing members 104a and 104b. For example, in order to form the connector holes, the holes 115a and 115b formed in the waterproof member 101 are preferably wider than the holes 125a and 125b formed in the protective member 102. However, because the connector holes are configured to be opened or closed by the sealing members 104a and 104b, the holes 115a and 115b and the holes 125a and 125b, which are formed in the protective member 102 to constitute the connector holes, may be formed in the same shape and size. It is apparent that the shapes may be different from each other depending on the connectors of the portable terminal 200 corresponding to the connector holes.

FIG. 8 is a cross-sectional view illustrating a sealing member coupled to a waterproof case such as, for example, the waterproof case illustrated in FIG. 2, according to an exemplary embodiment of the present invention.

Now, the constructions of the sealing members 104a and 104b will be described in more detail with reference to FIG. 8. FIG. 8 illustrates an example in which the sealing member 104a is configured to open or close a connector hole corresponding to an interface connector of the portable terminal 200. The construction for opening or closing an ear jack side connector hole of the portable terminal 200 may also be configured similar to the construction for opening or closing an interface connector side connector hole of the portable terminal 200.

Referring to FIG. 8, the sealing member 104a is assembled to the waterproof case 100 to open or close one of the connector holes such as, for example, a connector hole corresponding to the interface connector of the portable terminal 200. The sealing member 104a is preferably formed from an elastic material to be positioned in any direction in the opened state. As a result, in the state in which the connector hole is opened, a route for connecting a connector of an external device or a cable to the connector of the terminal through the connector hole can be sufficiently opened.

According to exemplary embodiments of the present invention, the sealing member 104a includes a connection part 143 joined to the waterproof case 100, more specifically to the protective member 102, and a sealing part 141 configured to open or close the connector hole. For example, the sealing part 141 is configured to make its outer perimeter come into close contact with the inner perimeter of a connector hole, more specifically with the inner perimeter of the hole 125b formed in the protective member 102 to seal the connector hole. The connection part 143 extends from the sealing part 141 and is arranged inside of the protective member 102. In order to join the sealing member 104a to the waterproof case 100, the connection part 143 is formed with a guide hole 145 in the form of an elongated opening extending in a direction, and the protective member 102 is formed with a guide protrusion 149 on the inner surface thereof. The connection part 143 is arranged inside of the protective member 102 in the state in which the guide hole 145 accommodates the guide protrusion 149. As a result, the connection part 143 is introduced into or extracted from the inside of the protective member 102 along the longitudinal direction of the guide hole 145 while being guided by the guide protrusion 149 and the guide hole 145. In addition, when the sealing member 104a opens the connector hole, it is possible to make the sealing part 141 sufficiently open the route for connecting a connector of an external device or a cable to the connector of the terminal through the connector hole.

According to exemplary embodiments of the present invention, the waterproof case 100 may further include a holding member 135b so that the connection part 143 can be prevented from being released from the guide protrusion 149. The holding member 135b is fixedly attached to the inner surface of the protective member 102, and is adapted to be partially engaged with the guide protrusion 149. Therefore, the connection part 143 is restrained by the guide protrusion 149 in the state in which the connection part 134 is interposed between the inner surface of the protective member 102 and the holding member 135b, and is allowed to move in the longitudinal direction of the guide hole 145.

According to exemplary embodiments of the present invention, the waterproof case 100 may further include a holding member 135a so that the sealing member 104b can be prevented from being released. As an example, the holding member 135a is fixedly attached to the inner surface of the protective member 102.

Preferably, the waterproof case 100 further includes a cover member 147 attached to the sealing member 104a, more specifically to the outer surface of the sealing part 141. Because the sealing part 141 is fabricated from an elastic material, such as, for example, rubber, silicone, urethane, or the like, whereas the protective member 102 is fabricated from a synthetic resin, such as, for example, polycarbonate, or the like, it is difficult to harmonize the sealing part 141 and the protective member 102 in terms of texture and color. Therefore, by attaching the cover member 147 formed of a rigid synthetic resin to the outer surface of the sealing part 141, so that the external appearance of the protective member 102, and hence the external appearance of the waterproof case 100 is made beautiful even in the state in which the connector hole is closed. In order to make the cover member 147 conceal the sealing part 141 and beautifully decorate the external appearance of the waterproof case 100 when the connector hole is closed, it is preferable to coherently adhere the cover member 147 to the outer surface of the protective member 102. It is more preferable to form a recess with a predetermined depth around the connector hole on the outer surface of the protective member 102 to accommodate the cover member 147.

In the construction illustrated in FIG. 8, the connection part 143 is exemplified as being configured to be arranged inside of the protective member 102 through the connector hole. However, it is also possible to form a separate hole in addition to the connector hole, so that the connection part 143 can be arranged in the inside of the protective member 102. In such a case, the holding member 135b should be configured to seal the separate hole for arranging the connection part 134 on the inner surface of the protective member 102. In addition, the cover member 147 should conceal the separate hole for arranging the connection part 143 as well as the sealing part 141 on the outer surface of the protective member 102.

When side keys are provided on the portable terminal 200 assembled to or otherwise installed in the waterproof case 100, the waterproof case 100 may further include key members 111a and 111b to manipulate the side keys. The key members 111a and 111b are preferably formed on the waterproof member 101 that is formed of an elastic material. In addition, the protective member 102 may further include key holes 121 for receiving the key members 111a and 111b. The key members 111a and 111b are arranged to be opposite to the side key members of the portable terminal 200 within the waterproof case 100, respectively, and are exposed to the outside of the waterproof case 100 through the key holes 121, respectively. Therefore, the user may manipulate the side keys even in a state in which the portable terminal 200 is assembled to the waterproof case 100.

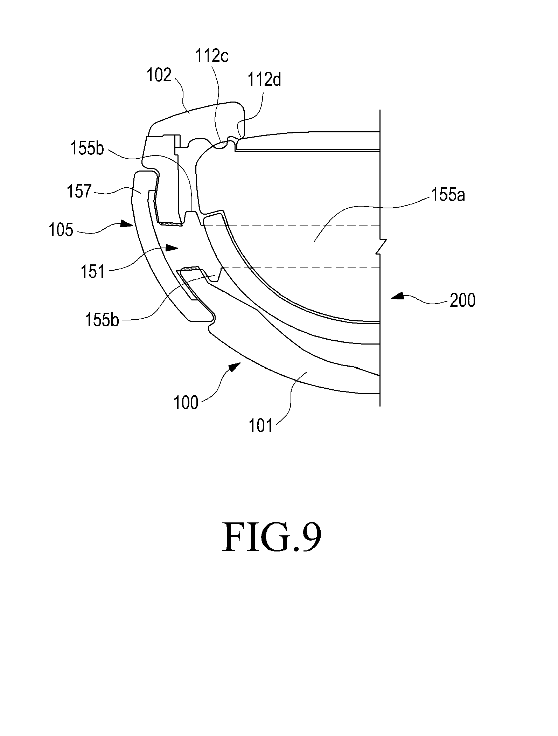

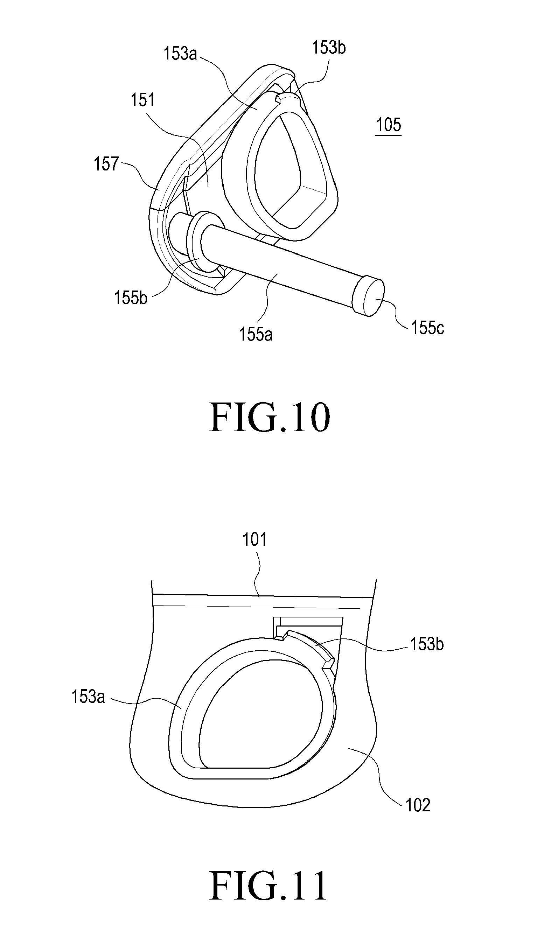

FIG. 9 is a cross-sectional view illustrating a variant embodiment of a sealing member coupled to a waterproof case such as, for example, the sealing member of FIG. 1, according to an exemplary embodiment of the present invention. FIG. 10 is a perspective view illustrating a sealing member such as, for example, the sealing member of FIG. 9, according to an exemplary embodiment of the present invention. FIG. 11 is a perspective view illustrating a sealing member coupled to a waterproof case such as, for example, the sealing member of FIG. 9, according to an exemplary embodiment of the present invention.

FIGs. 9 and 10 illustrate a variant of the sealing members 104a and 104b. Hereinafter, the sealing member illustrated in FIGs. 9 and 10 will be referred to as a "second sealing member." The second sealing member is indicated by reference numeral "105." As an example, the second sealing member 105 may be included to form a waterproof structure of a hole for providing a route for extending/retracting a whip antenna even when the portable terminal 200 is assembled to or otherwise installed in the waterproof case 100 in a case in which the whip antenna is provided in the portable terminal 200, which is configured to be retracted into or extended from the portable terminal 200. That is, when the portable terminal 200 is equipped with a whip antenna configured to be retracted into or extended from the portable terminal 200, the waterproof case 100 is formed with a hole for providing a route for retracting or extending the whip antenna. As a result, the user can extend the whip antenna without needing to separate the portable terminal 200 from the waterproof case 100. At this time, it is possible to implement a waterproof function to the hole for providing the route for retracting or extending the whip antenna by providing the second sealing member 105.

Referring to FIGs. 9 and 10, the second sealing member 105 includes a sealing part 151 formed from an elastic material, for example, rubber, silicone and urethane, a sealing protrusion 153a and a connection part 155a which extend from the inner surface of the sealing part 151. The sealing protrusion 153a and the connection part 155a are integrally formed with the sealing part 151.

According to exemplary embodiments of the present invention, the sealing protrusion 153a is formed to seal the hole formed in the waterproof case 100 to provide the route for retracting or extending the whip antenna, and is fit in the hole in such a manner that the outer circumferential surface thereof comes into close contact with the inner circumferential surface of the hole. According to exemplary embodiments of the present invention, as illustrated in FIGs. 10 and 11, the sealing protrusion 153a is formed with a first joint knob 153b on the outer circumferential thereof to be joined to the waterproof case 100, more specifically to the inner surface of the protective member 102. While the sealing protrusion 153a is being introduced into the hole, the first joint knob 135b is slidably contacted with the inner circumferential surface of the hole, and when the sealing protrusion 153a is fully introduced into the waterproof case 100, the first joint knob 153b is joined to the inner surface of the waterproof case 100 due to the elastic restoring force of the sealing protrusion 153a.

The connection part 155a is to connect the sealing part 151 to the waterproof member 101. The connection part 155a is formed in a rod shape extending from the inner surface of the sealing part 151, and has a circular cross-section. Therefore, the sealing part 151 may be rotated about an axis extending in the longitudinal direction of the connection part 155a. That is, the sealing part 151 can be rotated about the connection part 155a in the state in which the hole for providing the route for retracting or extending the whip antenna is opened. As a result, in the state in which the hole is opened, the sealing part 151 may be positioned at a location where it is not interfered with the whip antenna while the whip antenna is being retracted or extended.

The connection part 155a is installed in such a manner that its end is positioned inside of the waterproof case 100 through a coupling hole formed in the waterproof case 100. For example, the second sealing member 151 is connected to the waterproof case 100 through the connection part 155a. The connection part 155a may be provided with a second joint knob 155b and a stopper 155c. The stopper 155c is provided at the end of the connection part 155a so as to prevent the sealing part 151 from being completely separated from the waterproof case 100 at a position where the sealing part 151 is released from the waterproof case 100, in other words in a state in which the hole is opened. As illustrated in FIG. 9, the second joint knob 155b is joined to the inner surface of the waterproof case 100 in a state in which the sealing part 151 is in close contact with the waterproof case 100. According to exemplary embodiments of the present invention, the outer circumferential surface of the connection part 155a is completely engaged with the coupling hole of the waterproof case 100, and is somewhat pressed within the coupling hole of the waterproof case 100 between the inner surface of the sealing part 151 and the second joint knob 155b. For example, between the inner surface of the sealing part 151 and the second joint knob 155b, the cross-sectional diameter of the connection part 155a is larger than that of the coupling hole of the waterproof case 100. Therefore, it is possible to implement a waterproof function in the coupling hole of the waterproof case 100 in the state in which the second sealing member 105 is in close contact with the waterproof case 100. However, between the second joint knob 155b and the stopper 155c, the cross-sectional diameter of the connection part 155a is preferably smaller than that of the coupling hole of the waterproof case 100. This is to allow the user to freely control the position of the second sealing member 105 in the state in which the hole for retracting or extending the whip antenna.

According to exemplary embodiments of the present invention, if the outer surface of the waterproof case 100 is formed from a synthetic resin, the second sealing member 105 may be provided with a second cover member 157 formed from a rigid synthetic resin such as, for example, polycarbonate, so as to harmonize the outer appearance of the second sealing member 105 with the outer appearance of the waterproof case 100.

As discussed in the above, the waterproof case for a portable terminal according to exemplary embodiments of the present invention has an external appearance of an ordinary protective case while providing a waterproof function in daily use. As a result, the user can enjoy a screen without deteriorating picture quality even in the state in which the portable terminal is assembled to the protective case, and can freely manipulate a touch screen or side keys. In addition, by using sealing members, the waterproof case for a portable terminal according to exemplary embodiments of the present invention is adapted to freely open or close connector holes to allow a connector of the portable terminal to be connected to an external device while providing a waterproof function in daily life.

The waterproof case for a portable terminal according to exemplary embodiments of the present invention configured as described above has an advantage in that it can provide a waterproof function in daily life although it has an external appearance of a protective case for providing an ornamental function or a protective function against physical impact. In addition, the waterproof case is advantageous in that because the waterproof case allows the display device of the portable terminal to be opened while providing a waterproof function in daily life, it is possible to prevent the deterioration of picture quality of the display device, and to sufficiently use the touch screen function. Furthermore, because it is easy to provide a cover member for protecting various connectors, such as an interface connector and an earphone jack, an external device can be easily connected to the portable terminal even in the state in which the terminal is assembled to the waterproof case. Moreover, because the inventive waterproof case is formed with through-holes which correspond to sound input/output holes of the portable terminal, such as a microphone hole and a speaker phone hole, and waterproof and water-permeable films are attached to the through-holes, the inventive waterproof case can provide a waterproof function in daily life while enabling the inputting and outputting of sound. Consequently, the waterproof case for a portable terminal according to exemplary embodiments of the present invention can provide a waterproof function in daily life as well as normal ornamental and protective functions. In other words, the waterproof case may provide protection against scratches or other impact forces, an ornamental function, and protection against water (or other liquids) encountered in daily life.

As a non-exhaustive illustration only, a portable terminal described herein may refer to mobile devices such as a cellular phone, a Personal Digital Assistant (PDA), a digital camera, a portable game console, and an MP3 player, a Portable/Personal Multimedia Player (PMP), a handheld e-book, a portable lap-top PC, a Global Positioning System (GPS) navigation, and the like.

While the invention has been shown and described with reference to certain exemplary embodiments thereof, it will be understood by those skilled in the art that various changes in form and details may be made therein without departing from the spirit and scope of the invention as defined by the appended claims and their equivalents.

## Claims

1. A waterproof case for a portable terminal, the waterproof case comprising:
a waterproof member assembled to the portable terminal to wrap an outer perimeter of the portable terminal, the waterproof member being formed with an opening for partially exposing the portable terminal;
a protective member configured to wrap an outer perimeter of the waterproof member, the protective member being integrally formed with the waterproof member through dual injection molding; and
a waterproof rib formed from an elastic material around the opening on an inner surface of the waterproof member, the waterproof rib being configured to come into close contact with the outer perimeter of the portable terminal.

2. The waterproof case of claim 1, wherein the waterproof rib is formed in the shape of a looped curve that encloses the opening of the waterproof member.

3. The waterproof case of any one of claims 1 and 2, wherein the waterproof member and the waterproof rib are formed of a rubber material to be integrated with each other through injection molding.

4. The waterproof case of any one of claims 1 through 3, wherein the opening of the waterproof member is configured to expose a display device provided on one side of the portable terminal.

5. The waterproof case of any one of claims 1 through 4, wherein the waterproof rib is configured to come into close contact with lateral sides of the portable terminal.

6. The waterproof case of any one of claims 1 through 5, wherein the portable terminal comprises a housing and a window member for display installed on the front side of the housing, and
wherein the waterproof rib is configured to come into close contact with the outer perimeter of the portable terminal along the boundary between the housing and the window member.

7. The waterproof case of any one of claims 1 through 6, wherein the portable terminal comprises a window member for display mounted on the front side of the portable terminal, and
wherein the waterproof rib is configured to come into close contact with the outer surface of the window member.

8. The waterproof case of any one of claims 1 through 7, further comprising:
at least one through-hole connected to a sound input/output hole of the portable terminal; and
a waterproof and water-permeable film operatively attached to the through-hole.

9. The waterproof case of claim 8, wherein the waterproof and water-permeable film is operatively attached to the inner surface of the protective member.

10. The waterproof case of any one of claims 1 through 9, further comprising:
a connector hole connected to a connector of the terminal; and
a sealing member formed of an elastic material and configured to open or close the connector hole, wherein when the sealing member closes the connector hole, the outer perimeter of the sealing member comes into close contact with the inner perimeter of the connector hole on the protective member.

11. The waterproof case of claim 10, wherein the sealing member comprises:
a sealing part configured to open or close the connector hole; and
a connection part extending from the sealing part and operatively joined to the inner surface of the protective member, the connection part being adapted to be introduced into or extracted from the inside of the protective member.

12. The waterproof case of claim 11, further comprising a cover member operatively attached to the outer surface of the sealing part,
wherein when the sealing member closes the connector hole, the cover member comes into close contact with the outer perimeter of the protective member.

13. The waterproof case of any one of claims 11 and 12, further comprising:
a guide protrusion formed on the inner perimeter of the protective member; and
a guide hole formed in the connection part in a shape of an elongated opening, the guide hole being configured to be engaged with the guide protrusion, wherein the connection part is operatively joined to the inner perimeter of the protective member so as to be movable in the longitudinal direction of the guide hole.

14. The waterproof case of claim 13, further comprising a holding member operatively attached to the inner perimeter of the protective member to cover the guide protrusion,
wherein the connection part is interposed between the inner perimeter of the protective member and the holding member.

15. The waterproof case of any one of claims 10 through 14, wherein the sealing member comprises:
a sealing part configured to open or close the connector hole;
a rod-shaped connection part extending from the inner surface of the sealing part; and
a joint knob formed on the outer circumferential surface of the connection part, wherein when the connector hole is closed, the joint knob is operatively joined to the inner perimeter of the waterproof case to hold the sealing member.
